# EUROPEAN PATENT APPLICATION

(11) **EP 4 629 461 A1**
(43) Date of publication of application: **08.10.2025**
(21) Application number: 25166155.9
(22) Date of filing: 25.03.2025
(51) Int. Cl.: H02J 1/10, H02J 7/00, G01R 31/08, G01R 31/55

(54) **POWER SUPPLY SYSTEM**

(30) Priority: 27.03.2024 CN 202410366616
(71) Applicant: Huawei Digital Power Technologies Co., Ltd., Shenzhen, Guangdong 518043 (CN)
(72) Inventor: LI, Lin, Shenzhen 518043 (CN); HUANG, Liuliu, Shenzhen 518043 (CN); YANG, Boping, Shenzhen 518043 (CN)
(74) Representative: Gill Jennings & Every LLP

(57) **Abstract**

Embodiments of this application provide a power supply system. The power supply system includes a plurality of energy storage units and a plurality of power converters, and the energy storage unit is electrically connected to a corresponding power converter. A direct current power supply in the energy storage unit is electrically connected to a power conversion circuit in the power converter via at least two switches. First controllers in the energy storage units sequentially control actions of the at least two switches, so that direct current voltages output by direct current power supplies sequentially change. The second controller in the power converter obtains the direct current voltage received by the power conversion circuit; and when change amplitude of the direct current voltage is greater than a preset threshold, sends, through a communication connection, change information of the direct current voltage to the first controller that is communicatively connected to the second controller; otherwise, sends maintaining information of the direct current voltage. When controlling the voltage output by the direct current power supply to change and when receiving the maintaining information of the direct current voltage, or when not controlling the direct current voltage output by the direct current power supply to change and when receiving the change information of the direct current voltage, the first controller outputs a signal indicating a cable connection error.

## Description

### TECHNICAL FIELD

This application relates to the power electronics field, and in particular, to a power supply system.

### BACKGROUND

In an energy storage power supply system, one battery cluster is connected to a plurality of converters through power cables, and outputs direct currents through the power cables. In addition, the battery cluster is further connected to the converter through a communication cable, to transmit information such as a power scheduling instruction between the battery cluster and the converter. Currently, both the power cable and the communication cable between the battery cluster and the converter are routed in parallel through a ground trench, and consequently, a connection error may occur in the power cable and the communication cable. In other words, the battery cluster is connected to a converter through the power cable, while the battery cluster is connected to another converter through the communication cable. When the power cable and the communication cable between the battery cluster and the converter incorrectly match and are incorrectly connected, the battery cluster cannot normally communicate with the corresponding converter, the battery cluster cannot correctly schedule the converter to perform charging and discharging, and the battery cluster may even be damaged due to overcharge and overdischarge. In the current energy storage power supply system, when a connection error occurs in the power cable and the communication cable between the battery cluster and the converter, connections between the battery cluster and the converters are manually checked one by one. Cable checking is labor- and time-consuming and not efficient.

### SUMMARY

Embodiments of this application provide a power supply system, to prevent the power supply system from working when a connection abnormality occurs in a communication cable or a power cable between an energy storage unit and a power converter. This greatly improves efficiency of checking a connection of the communication cable or the power cable and working safety of the power supply system.

According to a first aspect, this application provides a power supply system. The power supply system includes a plurality of energy storage units and a plurality of power converters, each energy storage unit is electrically connected to at least one corresponding power converter, each energy storage unit includes a direct current power supply, a first controller, and at least two switches, and each power converter includes a power conversion circuit and a second controller. In each energy storage unit, the direct current power supply is electrically connected, via the at least two switches, to the power conversion circuit in the power converter corresponding to the energy storage unit, and is configured to output, via the at least two switches, an output direct current voltage to the power conversion circuit in the power converter corresponding to the energy storage unit. The first controllers in the energy storage units are sequentially configured to control actions of the at least two corresponding switches, so that direct current voltages output by direct current power supplies in the energy storage units sequentially change. In each power converter, the second controller is configured to: obtain the direct current voltage received by the power conversion circuit in the power converter; and when change amplitude of the direct current voltage is greater than a preset threshold, send, through a communication connection, change information of the direct current voltage to the first controller that is communicatively connected to the second controller; otherwise, send maintaining information of the direct current voltage to the first controller that is communicatively connected to the second controller. The first controller in each energy storage unit is configured to: when controlling the voltage output by the direct current power supply to change and when receiving the maintaining information of the direct current voltage, or when not controlling the direct current voltage output by the direct current power supply to change and when receiving the change information of the direct current voltage, output a signal indicating a cable connection error.

In this application, before supplying power to a load, the power supply system controls voltages between the energy storage units and the power converter to change, to check cable connections between the energy storage units and the power converters, so as to prevent the power supply system from working when a connection abnormality occurs in cables between the energy storage units and the power converters. This greatly improves efficiency of checking a connection of a communication cable or a power cable and working security of the power supply system. In addition, no additional hardware is required, and normal communication between other devices is not affected, so that accuracy of checking a connection of a communication cable or a power cable is high.

In a possible implementation, the first controller in each energy storage unit is configured to: receive at least one piece of maintaining information of the direct current voltage or change information of the direct current voltage; and when a quantity of pieces of received maintaining information of the direct current voltage or a quantity of pieces of received change information of the direct current voltage is less than a quantity of power converters corresponding to the energy storage unit, output a signal indicating a communication cable connection error or a power cable connection error. The quantity of pieces of change information of the direct current voltage or the quantity of pieces of maintaining information of the direct current voltage that is received by the controller in each battery cluster in the power supply system is detected. If the quantity of pieces of change information of the direct current voltage or the quantity of pieces of maintaining information of the direct current voltage that are received by the battery cluster is less than a quantity of converters corresponding to the battery cluster, it is determined that a connection abnormality occurs in power cables or communications cables between some battery clusters and corresponding converters, for example, a converter is not communicatively connected to any battery cluster. This expands a cable connection check range, and ensures working safety of the power supply system.

In a possible implementation, quantities of power converters corresponding to the energy storage units are the same, and the power supply system further includes an upper-level controller. The upper-level controller is configured to receive the maintaining information of the direct current voltage or the change information of the direct current voltage that is uploaded by first controllers in the plurality of energy storage units. The upper-level controller is configured to: when a quantity of pieces of maintaining information of the direct current voltage or a quantity of pieces of change information of the direct current voltage that is received by a first controller in one of the plurality of energy storage units is less than a quantity of pieces of maintaining information of the direct current voltage or a quantity of pieces of change information of the direct current voltage that is received by a first controller in another energy storage unit, output a signal indicating a communication cable connection error or a power cable connection error. The quantity of pieces of change information of the direct current voltage or the quantity of pieces of maintaining information of the direct current voltage that is received by the controller in each battery cluster in the power supply system is detected. If the quantity of pieces of change information or the quantity of pieces of maintaining information received by the controller in each battery cluster are different, it is determined that a connection abnormality occurs in power cables or communications cables between some battery clusters and corresponding converters, for example, a converter has no communication connection or power connection to any battery cluster. This expands a cable connection check range, and ensures working safety of the power supply system.

In a possible implementation, a positive electrode and a negative electrode of the direct current power supply are respectively connected to a positive input and a negative input of the power conversion circuit, and the at least two switches are connected in series between the positive electrode of the direct current power supply and the positive input of the power conversion circuit. An action of a switch in a soft-start circuit in the energy storage unit is controlled, so that a voltage between the energy storage unit and the power converter changes. A connection of a communication cable or a power cable between the energy storage unit and the power converter is checked, to prevent the power supply system from working when a connection abnormality occurs in the cable between the energy storage unit and the power converter.

In a possible implementation, a positive electrode and a negative electrode of the direct current power supply are respectively connected to a positive input and a negative input of the power conversion circuit, and the at least two switches are connected in series between the negative electrode of the direct current power supply and the negative input of the power conversion circuit. An action of the switch in the soft-start circuit in the energy storage unit is controlled, so that the voltage between the energy storage unit and the power converter changes. The connection of the communication cable or the power cable between the energy storage unit and the power converter is checked, to prevent the power supply system from working when a connection abnormality occurs in the cable between the energy storage unit and the power converter.

In a possible implementation, the energy storage unit includes a first switch, a second switch, and a first resistor, the first resistor is connected in series to the first switch, and the second switch is connected in parallel to two ends of the first resistor and the first switch that are connected in series. The first controller in each energy storage unit is configured to control the first switch to be turned on, so that the direct current voltage output by the direct current power supply in the energy storage unit is a first voltage. The first controller in each energy storage unit is configured to: after the second controller in the power converter corresponding to the first controller obtains the first voltage, control the second switch to be turned on, so that the direct current voltage output by the direct current power supply in the energy storage unit is increased to a second voltage. An absolute value of a difference between the first voltage and the second voltage is greater than the preset threshold. An action of the switch in the soft-start circuit in the energy storage unit is controlled, so that the voltage between the energy storage unit and the power converter changes. The connection of the communication cable or the power cable between the energy storage unit and the power converter is checked, to prevent the power supply system from working when a connection abnormality occurs in the cable between the energy storage unit and the power converter.

In a possible implementation, the energy storage unit includes a first switch, a second switch, a third switch, a first resistor, a second resistor, and a third resistor, the first resistor is connected in series to the first switch, the second switch is connected in parallel to two ends of the first resistor and the first switch that are connected in series, one end of the second resistor is connected to connection ends of the first resistor and the second switch, and the other end of the second resistor is connected to connection ends of the first switch and the second switch via the third switch. The first controller in each energy storage unit is configured to control the first switch to be turned on, so that a direct current voltage output by the direct current power supply in the energy storage unit is a third voltage. The first controller in each energy storage unit is configured to: after the second controller in the power converter corresponding to the first controller obtains the third voltage, control the second switch to be turned on, so that the direct current voltage output by the direct current power supply in the energy storage unit is increased to a fourth voltage. An absolute value of a difference between the third voltage and the fourth voltage is greater than the preset threshold. When the first switch in the soft-start circuit is turned on, the first resistor and the second resistor are connected in series to the power connection between the energy storage unit and the power converter. When the second switch in the soft-start circuit is turned on, the first resistor is connected in series to the power connection between the energy storage unit and the power converter. This can avoid excessively large change amplitude of the output voltage of the energy storage unit before and after the second switch is turned on, to protect the switch in the soft-start circuit.

In a possible implementation, the energy storage unit includes a first communication port, the power converter includes a second communication port, and first communication ports of the plurality of energy storage units are configured to be connected to second communication ports of the plurality of power converters through communication cables. The second controller in each power converter is configured to transmit, through the communication cable connected to the second communication port, the maintaining information of the direct current voltage or the change information of the direct current voltage to the first controller that is communicatively connected to the second controller. The first controller in each energy storage unit is configured to: when controlling the voltage output by the direct current power supply to change and when receiving the maintaining information of the direct current voltage through the communication cable connected to the first communication port, or when not controlling the direct current voltage output by the direct current power supply to change and when receiving the change information of the direct current voltage through the communication cable connected to the first communication port, output the signal indicating a cable connection error. Voltages between the energy storage units and the power converters are controlled to change, to check connections of communication cables or power cables between the energy storage units and the power converters, so as to prevent the power supply system from working when a connection abnormality occurs in cables between the energy storage units and the power converters. This greatly improves efficiency of checking a connection of a communication cable or a power cable and working security of the power supply system.

### BRIEF DESCRIPTION OF DRAWINGS

FIG. 1 is a diagram of an application scenario of a power supply system according to this application;
FIG. 2 is a diagram of another application scenario of a power supply system according to this application;
FIG. 3 is a schematic of a structure of a power supply system according to this application;
FIG. 4 is a schematic of another structure of a power supply system according to this application;
FIG. 5 is a schematic of another structure of a power supply system according to this application;
FIG. 6 is a schematic of another structure of a power supply system according to this application;
FIG. 7 is a schematic of another structure of a power supply system according to this application; and
FIG. 8 is a schematic of another structure of a power supply system according to this application.

### DESCRIPTION OF EMBODIMENTS

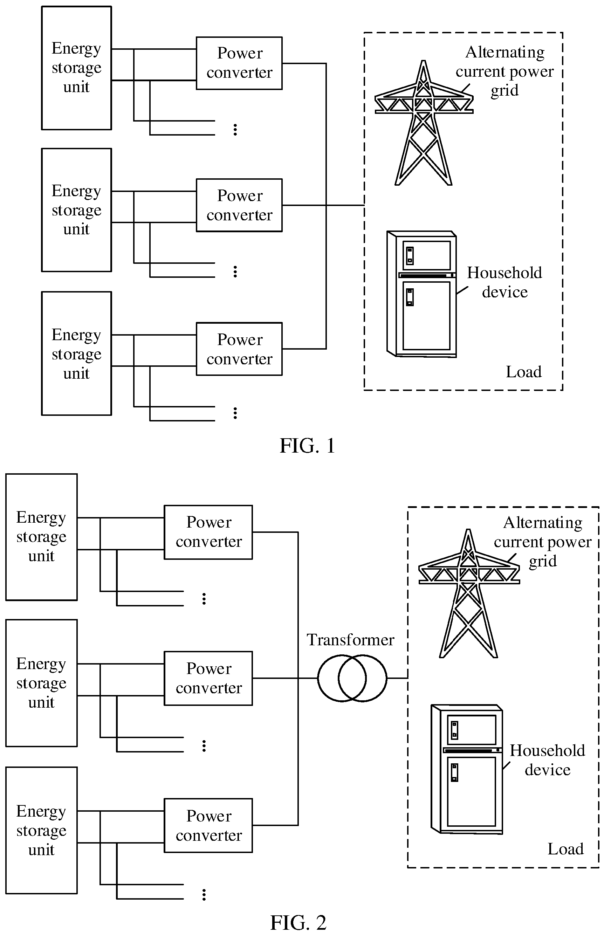

FIG. 1 is a diagram of an application scenario of a power supply system according to this application. The power supply system provided in this application may include a plurality of energy storage units and a plurality of power converters. The energy storage unit includes a direct current power supply and a controller (not shown in FIG. 1). The direct current power supply in each energy storage unit is connected to an input of at least one power converter through a power cable, and an output of each power converter is connected to a load. The power converter may invert a direct current provided by the direct current power supply, and output an alternating current to the load. The load may be an alternating current power grid or an alternating current power-consuming device. When the power converter is grid-connected, the load may be an alternating current power grid. When the power converter is off-the-grid, the load may be an alternating current power-consuming device like a household device.

In some feasible implementations, the power supply system may include a transformer. FIG. 2 is a diagram of another application scenario of a power supply system according to this application. The output of each power converter may be connected to the load by using the transformer. The transformer may change (which may be a boost, a buck, or the like) an alternating current provided by the power converter, and supply a transformed alternating current to the load.

In the application scenario of the power supply system shown in FIG. 1 or FIG. 2, the direct current power supply in each energy storage unit is connected to the input of the at least one power converter through the power cable, and the power converter obtains, through the power cable, the direct current provided by the direct current power supply. In addition, a communication cable is further included between the energy storage unit and the power converter, to transmit information such as a power scheduling instruction between the energy storage unit and the power converter. For example, the energy storage unit sends, through the communication cable, the power scheduling instruction to the power converter that has a power connection to the energy storage unit, and obtains, through the communication cable, information about power actually output by the corresponding power converter. The communication cable between the energy storage unit and the power converter may be a wired communication cable or wireless communication. For example, the communication cable between the energy storage unit and the power converter is a wired communication cable. When one energy storage unit is connected to one power converter through a power cable, and the energy storage unit is connected to another power converter through a communication cable, the power cable and the communication cable between the energy storage unit and the power converter incorrectly match and are incorrectly connected. When the power cable and the communication cable between the energy storage unit and the power converter in the power supply system incorrectly match and are incorrectly connected, the energy storage unit cannot normally communicate with the corresponding power converter, and the energy storage unit cannot correctly schedule the power converter to perform charging and discharging. In the current power supply system, when a connection error occurs in the power cable and the communication cable between the energy storage unit and the power converter, connections between the energy storage units and the power converters are manually checked one by one, which is labor- and time-consuming and not efficient.

This application provides a power supply system. The power supply system includes a plurality of energy storage units and a plurality of power converters, and each energy storage unit is electrically connected to at least one corresponding power converter. Each energy storage unit includes a direct current power supply, a first controller, and at least two switches, and each power converter includes a power conversion circuit and a second controller. In each energy storage unit, the direct current power supply is electrically connected, via the at least two switches, to the power conversion circuit in the power converter corresponding to the energy storage unit, and is configured to output, via the at least two switches, an output direct current voltage to the power conversion circuit in the power converter corresponding to the energy storage unit. The first controllers in the energy storage units are sequentially configured to control actions of the at least two corresponding switches, so that direct current voltages output by direct current power supplies in the energy storage units sequentially change. For example, in the plurality of energy storage units in the power supply system, in each round of communication connection detection, a first controller in one energy storage unit controls actions of at least two switches included in the energy storage unit, so that a voltage output by a direct current power supply in the energy storage unit to a power conversion circuit in a corresponding power converter changes. Then, in each power converter, the second controller is configured to: obtain a direct current voltage received by the power conversion circuit in the power converter; and when change amplitude of the direct current voltage is greater than a preset threshold, send, through a communication connection, change information of the direct current voltage to the first controller that is communicatively connected to the second controller; otherwise, send maintaining information of the direct current voltage to the first controller that is communicatively connected to the second controller. Further, the first controller in each energy storage unit is configured to: when controlling the voltage output by the direct current power supply to change and when receiving the maintaining information of the direct current voltage, or when not controlling the direct current voltage output by the direct current power supply to change and when receiving the change information of the direct current voltage, output a signal indicating a cable connection error. In this round of cable connection detection, a connection error of a communication cable or a power cable is detected, and the cable connection detection ends. If none of the plurality of energy storage units outputs a signal indicating a cable connection error, a next round of communication connection detection continues to be performed, and a first controller in another energy storage unit controls actions of at least two switches included in the another energy storage unit, until the first controller in each energy storage unit in the power supply system controls actions of at least two switches included in the energy storage unit, so that the voltage output by the direct current power supply to the power converter changes. Before supplying power to a load, the power supply system controls voltages between the energy storage units and the power converters to change, to check connections of communication cables or power cables between the energy storage units and the power converters, so as to prevent the power supply system from working when a connection abnormality occurs in cables between the energy storage units and the power converters. This greatly improves efficiency of checking a connection of a communication cable or a power cable and working security of the power supply system. In addition, no additional hardware is required, and normal communication between other devices is not affected, so that accuracy of checking a connection of a communication cable or a power cable is high.

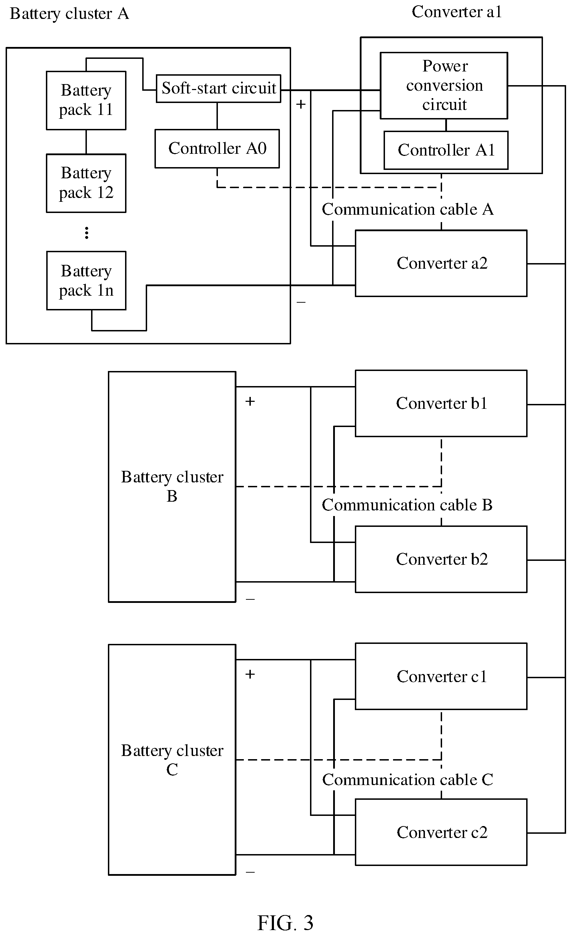

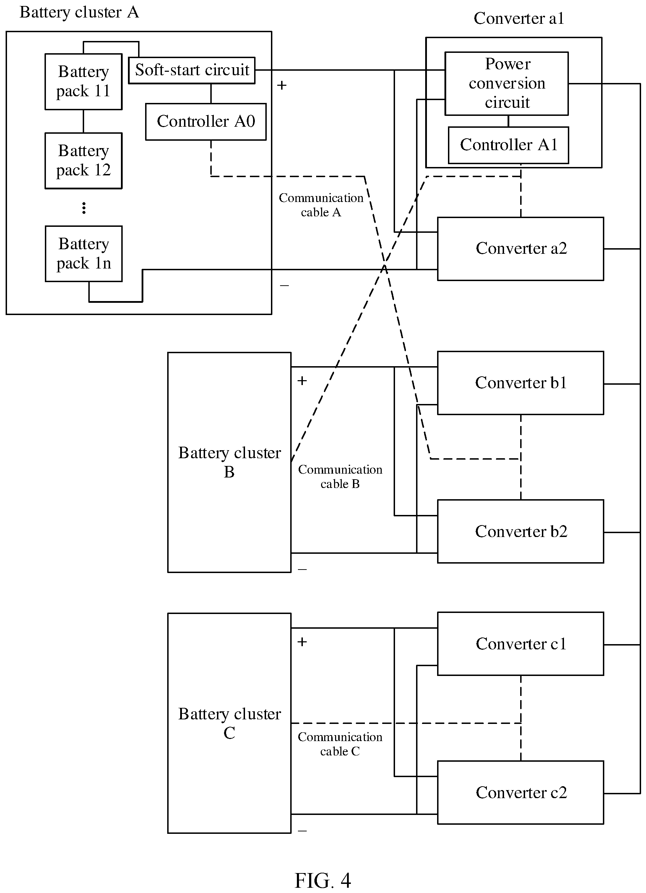

In some feasible implementations, in the power supply system, the energy storage unit is a battery cluster, and the power converter is a converter. FIG. 3 is a schematic of a structure of a power supply system according to this application. The power supply system shown in FIG. 3 includes a plurality of battery clusters and a plurality of converters. Each battery cluster includes a direct current power supply and a first controller, and the direct current power supply is a plurality of battery packs connected in series. The converter includes a power conversion circuit and a second controller, and the power conversion circuit is configured to convert a direct current output by the battery cluster into an alternating current. For example, a battery cluster A includes a battery pack 11, a battery pack 12, ..., and a battery pack 1n that are connected in series and a controller A0. The direct current power supply in each battery cluster is electrically connected to an input of at least one converter through a power cable. For example, the direct current power supply in the battery cluster is connected to two converters through power cables. One end of the battery pack 11 in the battery cluster A may be used as a positive electrode of the direct current power supply in the battery cluster, and is connected to a positive input of a power conversion circuit in a converter a1 and a positive input of a power conversion circuit in a converter a2 through the power cables. One end of the battery pack 1n may be used as a negative electrode of the direct current power supply in the battery cluster, and is connected to a negative input of the power conversion circuit in the converter a1 and a negative input of the power conversion circuit in the converter a2 through the power cables. Outputs of the converter a1 and the converter a2 may be connected to a transformer or a load. Internal circuit structures of a battery cluster B and a battery cluster C are similar to that of the battery cluster A, and connection manners in which the battery cluster B is connected to a converter b1 and a converter b2 and the battery cluster C is connected to a converter c1 and a converter c2 are also similar to a connection manner in which the battery cluster A is connected to the converter a1 and the converter a2. Details are not described herein again. In addition, a communication cable is further included between the battery cluster and the converter, to transmit information such as a power scheduling instruction between the battery cluster and the converter. For example, the battery cluster A sends, through the communication cable, the power scheduling instruction to the converter a1 and the converter a2 that have power connections to the battery cluster A, and obtains, through the communication cable, information about power actually output by the converter a1 and the converter a2. The communication cable between the battery cluster and the converter in the power supply system may be a wired communication cable or wireless communication. Still refer to FIG. 3. When the communication cable between the battery cluster and the converter is a wired communication cable, the battery cluster A may be connected to the converter a1 and the converter a2 through a communication cable A. For example, a communication port of the battery cluster A may be connected to a communication port of the converter a1 and a communication port of the converter a2 through the communication cable A. The controller A0 in the battery cluster A is connected to the communication cable A. The controller A0 sends power scheduling instructions to a controller A1 in the converter a1 and a controller A2 (not shown in FIG. 3) in the converter a2 through the communication cable A, or obtains, through the communication cable A, information about power output by the controller A1 in the converter a1 and the controller A2 in the converter a2. Similarly, in FIG. 3, the battery cluster B is connected to the converter b1 and the converter b2 through the communication cable B, and the battery cluster C is connected to the converter c1 and the converter c2 through the communication cable C. For a process in which the battery cluster B communicates with the converter b1 and the converter b2 and a process in which the battery cluster C communicates with the converter c1 and the converter c2, refer to the foregoing descriptions about the battery cluster A. Details are not described herein again. When the power cable and the communication cable between the battery cluster and the converter in the power supply system incorrectly match and are incorrectly connected, the battery cluster cannot normally communicate with the corresponding converter. FIG. 4 is a schematic of another structure of a power supply system according to this application. In the power supply system shown in FIG. 4, the battery cluster A is connected to the converter a1 and the converter a2 through power cables, the battery cluster B is connected to the converter b1 and the converter b2 through power cables, and the battery cluster C is connected to the converter c1 and the converter c2 through power cables. However, the battery cluster A is connected to the converter b1 and the converter b2 through the communication cable A, the battery cluster B is connected to the converter a1 and the converter a2 through the communication cable B, and the battery cluster C is connected to the converter c1 and the converter c2 through the communication cable C. In other words, a connection error occurs in communication cables of the battery cluster A and the battery cluster B.

In the power supply systems shown in FIG. 3 and FIG. 4, the power cable between the direct current power supply in the battery cluster and the positive input of the converter may include a soft-start circuit, or the power cable between the direct current power supply in the battery cluster and the negative input of the converter may include a soft-start circuit. For example, the power cable between the direct current power supply and the positive input of the converter includes a soft-start circuit. Still refer to FIG. 3 and FIG. 4. The battery cluster A includes the battery pack 11, the battery pack 12, ..., and the battery pack 1n that are connected in series, the controller A0, and the soft-start circuit. One end of the battery pack 11 is connected to the positive input of the power conversion circuit in the converter a1 and the positive input of the power conversion circuit in the converter a2 through the power cables, and the soft-start circuit included in the battery cluster A is located on the power cable between the battery pack 11 and the positive input of the power conversion circuit in the converter a1 and the positive input of the power conversion circuit in the converter a2. The soft-start circuit may include at least two switches. The power supply system shown in FIG. 4 is used as an example. In a cable connection checking process, the controller A0 in the battery cluster A, a controller B0 in the battery cluster B, and a controller C0 in the battery cluster C may be sequentially configured to control actions of at least two corresponding switches, so that direct current voltages output by direct current power supplies in the energy storage units sequentially change, until any controller sends a signal indicating a cable connection error. For example, the controller A0 in the battery cluster A controls actions of the switches in the soft-start circuit, so that a voltage that is output, to the converter a1 and the converter a2, by the battery pack connected in series, is increased from a first voltage to a second voltage. The controller in each converter obtains the direct current voltage received by the corresponding power conversion circuit. When it is detected that the voltage changes, that is, change amplitude of the direct current voltage is greater than a preset threshold, or an absolute value of a change difference of the direct current voltage is greater than a preset threshold, the controller sends, through a communication connection, change information of the direct current voltage to the first controller (which may be a first controller in one of the plurality of energy storage units) that is communicatively connected to the controller; otherwise, sends maintaining information of the direct current voltage to the first controller that is communicatively connected to the controller. For example, the controller A1 in the converter a1 obtains the direct current voltage received by the corresponding power conversion circuit, and the controller A2 in the converter a2 obtains the direct current voltage received by the corresponding power conversion circuit. Because the voltage output by the battery cluster A to the converter a1 and the converter a2 is increased from the first voltage to the second voltage, the controller A1 and the controller A2 detect that the change amplitude of the direct current voltage is greater than the preset threshold, and send the change information of the direct current voltage to the controller B0 in the battery cluster B through the communication connection. Similarly, a controller B1 in the converter b1 obtains the direct current voltage received by the corresponding power conversion circuit, and a controller B2 in the converter b2 obtains the direct current voltage received by the corresponding power conversion circuit. Because the voltage output by the battery cluster B to the converter b1 and the converter b2 remains unchanged, the controller B1 and the controller B2 detect that the change amplitude of the direct current voltage is not greater than the preset threshold, and send the maintaining information of the direct current voltage to the controller A0 in the battery cluster A through the communication connection. In this case, because the voltage output by the battery cluster C to the converter c1 and the converter c2 remains unchanged, the controller C1 in the converter c1 and the controller C2 in the converter c2 detect that the change amplitude of the direct current voltage is not greater than the preset threshold, and send the maintaining information of the direct current voltage to the controller in the battery cluster C through the communication connection. Further, the controller A0 in the battery cluster A receives the maintaining information of the direct current voltage from the converter b1 and the converter b2, controls the voltage output by the battery pack to the converter a1 and the converter a2 to increase from the first voltage to the second voltage, and outputs the signal indicating a cable connection error. The controller B0 in the battery cluster B receives the change information of the direct current voltage from the converter a1 and the converter a2, does not control the voltage output by the battery pack to the converter b1 and the converter b2 to change, and also outputs the signal indicating a cable connection error. Before supplying power to the load, the power supply system controls voltages between the energy storage units and the power converter to change, to check cable connections between the energy storage units and the power converters, so as to prevent the power supply system from working when a connection abnormality occurs in cables between the energy storage units and the power converters. This greatly improves efficiency of cable connection checking and working security of the power supply system. In addition, no additional hardware is required, and normal communication between other devices is not affected, so that accuracy of cable connection checking is high.

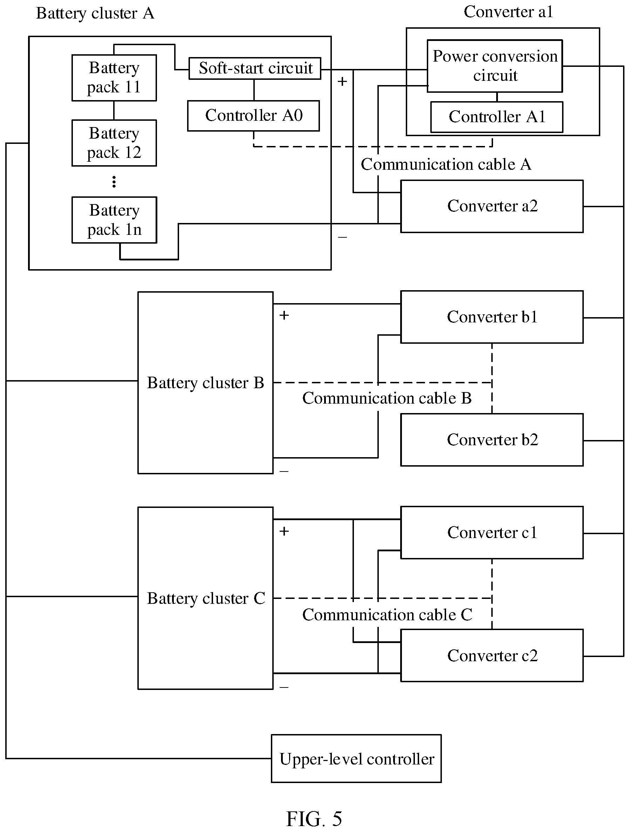

In some feasible implementations, the first controller in each energy storage unit is configured to: receive at least one piece of maintaining information of the direct current voltage or change information of the direct current voltage; and when a quantity of pieces of received maintaining information of the direct current voltage or a quantity of pieces of received change information of the direct current voltage is less than a quantity of power converters corresponding to the energy storage unit, output a signal indicating a communication cable connection error or a power cable connection error. The signal indicating a cable connection error may include the signal indicating a communication cable connection error or a power cable connection error. FIG. 5 is a schematic of another structure of a power supply system according to this application. In the power supply system shown in FIG. 5, quantities of corresponding power converters that are electrically connected to the energy storage units are the same. The battery cluster A is connected to the converter a1 and the converter a2 through power cables, the battery cluster A is connected to the converter a1 through the communication cable A, and the converter a2 is not connected to the communication cable A. The battery cluster B is connected to the converter b1 through the power cable, the battery cluster B is not connected to the converter b2 through the power cable, and the battery cluster B is connected to the converter b1 and the converter b2 through the communication cable B. The battery cluster C is connected to the converter c1 and the converter c2 through power cables, and the battery cluster C is connected to the converter c1 and the converter c2 through the communication cable C. In a cable connection checking process, the controller A0 in the battery cluster A, the controller B0 in the battery cluster B, and the controller C0 in the battery cluster C may sequentially control voltages output by the battery clusters in which the controllers respectively are located to change, until any controller sends the signal indicating a cable connection error. For example, the controller A0 in the battery cluster A controls actions of the switches in the soft-start circuit, so that the voltage that is output, to the converter a1 and the converter a2, by the battery pack connected in series, is increased from the first voltage to the second voltage. For example, the controller A1 in the converter a1 obtains the direct current voltage received by the corresponding power conversion circuit, and the controller A2 in the converter a2 obtains the direct current voltage received by the corresponding power conversion circuit. Because the voltage output by the battery cluster A to the converter a1 and the converter a2 is increased from the first voltage to the second voltage, the controller A1 and the controller A2 detect that the change amplitude of the direct current voltage is greater than the preset threshold, the controller A1 sends the change information of the direct current voltage to the controller A0 in the battery cluster A through the communication connection, and the controller A2 cannot send the change information of the direct current voltage because the controller A2 is not connected to the communication cable A. The controller B1 in the converter b1 obtains the direct current voltage received by the corresponding power conversion circuit. Because the voltage output by the battery cluster B to the converter b1 remains unchanged, the controller B1 detects that the change amplitude of the direct current voltage is not greater than the preset threshold, and sends the maintaining information of the direct current voltage to the controller B0 in the battery cluster B through the communication connection. Because the converter b2 has no power connection to the battery cluster B, the converter b2 cannot receive the voltage provided by the battery cluster B. Because the battery cluster B does not supply power to the controller B2 in the converter b2, the controller B2 cannot send the maintaining information of the direct current voltage. In this case, because the voltage output by the battery cluster C to the converter c1 and the converter c2 remains unchanged, the controller C1 in the converter c1 and the controller C2 in the converter c2 detect that the change amplitude of the direct current voltage is not greater than the preset threshold, and send the maintaining information of the direct current voltage to the controller in the battery cluster C through the communication connection. Because the controller in each battery cluster does not receive the maintaining information of the direct current voltage and controls the voltage output by the corresponding battery cluster to change, or receives the change information of the direct current voltage and does not control the voltage of the corresponding battery cluster to change, no controller sends the signal indicating a cable connection error in this round of cable connection checking. Then, the controller A0 in the battery cluster A detects that the controller A0 receives one piece of change information of the direct current voltage, and the battery cluster A corresponds to two converters. In this case, the controller A0 in the battery cluster A outputs the signal indicating a communication cable connection error. The quantity of pieces of change information of the direct current voltage or the quantity of pieces of maintaining information of the direct current voltage that is received by the controller in each battery cluster in the power supply system is detected. If the quantity of pieces of change information of the direct current voltage or the quantity of pieces of maintaining information of the direct current voltage that is received by the battery cluster is less than a quantity of converters corresponding to the battery cluster, it is determined that a connection abnormality occurs in power cables or communications cables between some battery clusters and corresponding converters, for example, a converter is not communicatively connected to any battery cluster. This expands a cable connection check range, and ensures working safety of the power supply system.

In some feasible implementations, the power supply system may include an upper-level controller, and the upper-level controller is configured to receive the maintaining information of the direct current voltage or the change information of the direct current voltage that are uploaded by a plurality of first controllers in the plurality of energy storage units. The upper-level controller is further configured to: after the first controller in any energy storage unit controls actions of at least two switches, when the quantity of pieces of maintaining information of the direct current voltage or the quantity of pieces of change information of the direct current voltage that is received by a first controller in one of the plurality of energy storage units is less than a quantity of pieces of maintaining information of the direct current voltage or a quantity of pieces of change information of the direct current voltage that is received by a first controller in another energy storage unit, output the signal indicating a cable connection error. The signal indicating a cable connection error may include a signal indicating a communication cable connection error or a power cable connection error. Still refer to FIG. 5. In a cable connection checking process, the controller A0 in the battery cluster A, the controller B0 in the battery cluster B, and the controller C0 in the battery cluster C may sequentially control voltages output by the battery clusters in which the controllers respectively are located to change, until any controller sends the signal indicating a cable connection error. For example, the controller A0 in the battery cluster A controls actions of the switches in the soft-start circuit, so that the voltage that is output, to the converter a1 and the converter a2, by the battery pack connected in series, is increased from the first voltage to the second voltage. For example, the controller A1 in the converter a1 obtains the direct current voltage received by the corresponding power conversion circuit, and the controller A2 in the converter a2 obtains the direct current voltage received by the corresponding power conversion circuit. Because the voltage output by the battery cluster A to the converter a1 and the converter a2 is increased from the first voltage to the second voltage, the controller A1 and the controller A2 detect that the change amplitude of the direct current voltage is greater than the preset threshold, the controller A1 sends the change information of the direct current voltage to the controller A0 in the battery cluster A through the communication connection, and the controller A2 cannot send the change information of the direct current voltage because the controller A2 is not connected to the communication cable A. The controller B1 in the converter b1 obtains the direct current voltage received by the corresponding power conversion circuit. Because the voltage output by the battery cluster B to the converter b1 remains unchanged, the controller B1 detects that the change amplitude of the direct current voltage is not greater than the preset threshold, and sends the maintaining information of the direct current voltage to the controller B0 in the battery cluster B through the communication connection. Because the converter b2 has no power connection to the battery cluster B, the converter b2 cannot receive the voltage provided by the battery cluster B. Because the battery cluster B does not supply power to the controller B2 in the converter b2, the controller B2 cannot send the maintaining information of the direct current voltage. In this case, because the voltage output by the battery cluster C to the converter c1 and the converter c2 remains unchanged, the controller C1 in the converter c1 and the controller C2 in the converter c2 detect that the change amplitude of the direct current voltage is not greater than the preset threshold, and send the maintaining information of the direct current voltage to the controller in the battery cluster C through the communication connection. Because the controller in each battery cluster does not receive the maintaining information of the direct current voltage and controls the voltage output by the corresponding battery cluster to change, or receives the change information of the direct current voltage and does not control the voltage of the corresponding battery cluster to change, no controller sends the signal indicating a cable connection error in this round of cable connection checking. Then, the upper-level controller in the power supply system may obtain quantities of pieces of change information of direct current voltages or quantities of pieces of maintaining information of direct current voltages that are received by the controllers in the battery clusters. When the quantity of pieces of maintaining information of the direct current voltage or the quantity of pieces of change information of the direct current voltage that are received by a controller in one battery cluster is less than a quantity of pieces of maintaining information of the direct current voltage or a quantity of pieces of change information of the direct current voltage that is received by a controller in another battery cluster, output the signal indicating a communication cable connection error or a power cable connection error. For example, the upper-level controller may separately obtain the quantity of pieces of change information of the direct current voltage or the quantity of pieces of maintaining information of the direct current voltage that is received by the controllers in the battery cluster A, the battery cluster B, and the battery cluster C, that is, the battery cluster A receives one piece of change information of the direct current voltage, the battery cluster B receives one piece of maintaining information of the direct current voltage, and the battery cluster C receives two pieces of maintaining information of the direct current voltage. Because the quantity of pieces of change information of the direct current voltage or the quantity of pieces of maintaining information of the direct current voltage that is received by the controllers in the battery cluster A and the battery cluster B is less than the quantity of pieces of change information of the direct current voltage or the quantity of pieces of maintaining information of the direct current voltage that is received by the controller in the battery cluster C, the upper-level controller outputs the signal indicating a communication cable connection error or a power cable connection error. The quantity of pieces of change information of the direct current voltage or the quantity of pieces of maintaining information of the direct current voltage that is received by the controller in each battery cluster in the power supply system is detected. If the quantity of pieces of change information or the quantity of pieces of maintaining information received by the controller in each battery cluster are different, it is determined that a connection abnormality occurs in power cables or communications cables between some battery clusters and corresponding converters, for example, a converter has no communication connection or power connection to any battery cluster. This expands a cable connection check range, and ensures working safety of the power supply system.

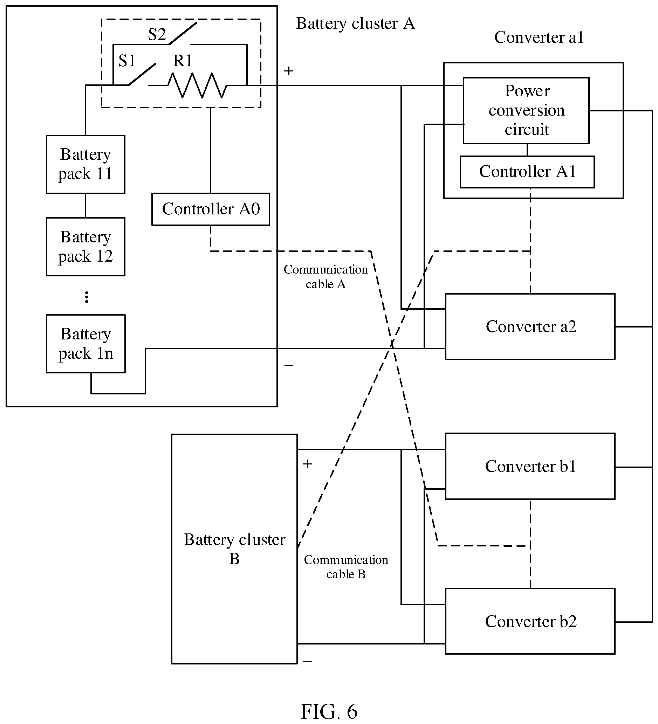

In some feasible implementations, the soft-start circuit in the battery cluster may include a first switch, a second switch, and a first resistor, the first resistor is connected in series to the first switch, and the second switch is connected in parallel to two ends of the first resistor and the first switch that are connected in series. The first controller in the battery cluster is configured to control the first switch to be turned on, so that a voltage output by the battery pack in the battery cluster to the corresponding converter is a first voltage. The first controller in the battery cluster is further configured to: after the second controller in the converter corresponding to the battery cluster obtains the first voltage, control the second switch to be turned on, so that the voltage output by the battery pack in the battery cluster to the corresponding converter is increased to a second voltage. An absolute value of a difference between the first voltage and the second voltage is greater than the preset threshold. Specifically, in a cable connection checking process, the controllers in the battery clusters may control first switches respectively included in the battery clusters to be turned on, and sequentially control second switches to be turned on, to control voltages output by the battery clusters in which the controllers respectively are located to change, until any controller sends the signal indicating a cable connection error. FIG. 6 is a schematic of another structure of a power supply system according to this application. In the power supply system shown in FIG. 6, the soft-start circuit in the battery cluster A includes a switch S1, a switch S2, and a resistor R1. One end of the battery pack 11 in the battery cluster A is connected to the positive input of the converter a1 and the positive input of the converter a2 through power cables, and the switch S1 and the resistor R1 that are connected in series and that are included in the battery cluster are located on a power cable between the battery pack 11 and the positive input of the converter a1. The switch S2 in the battery cluster is connected in parallel to two ends of the switch S1 and the resistor R1 that are connected in series. Composition and a component connection manner of a soft-start circuit in the battery cluster B in the power supply system are similar to those of the soft-start circuit in the battery cluster A. Details are not described herein again. In a cable connection check process, the controller in each battery cluster may control the first switch respectively included in the battery cluster to be turned on. For example, the controller A0 in the battery cluster A may control the switch S1 to be turned on, so that a voltage output by the battery pack in the battery cluster A to the converter a1 and the converter a2 is U1. Then, the controller A1 in the converter a1 and the controller A2 (not shown in FIG. 6) in the converter a2 may obtain U1 at inputs of the corresponding power conversion circuits. Similarly, the controller in the converter b1 and the controller in the converter b2 may also obtain, at inputs of the corresponding power conversion circuits, the voltage currently provided by the battery pack in the battery cluster B. The controllers in the battery clusters may sequentially control corresponding second switches to be turned on, to control voltages output by the battery clusters in which the controllers are located to change. For example, the controller A0 in the battery cluster A may control the switch S2 to be turned on, so that the resistor R1 is bypassed, and the voltage output by the battery pack in the battery cluster A to the converter a1 and the converter a2 is increased to U2. The controller A1 in the converter a1 and the controller A2 in the converter a2 may obtain U2 at inputs of the corresponding power conversion circuits, and detect that an absolute value of a difference between U2 and U1 is greater than the preset threshold. The controller A1 in the converter a1 and the controller A2 in the converter a2 may send the change information of the direct current voltage to the controller in the battery cluster B through the communication connection. The controller in the converter b1 and the controller in the converter b2 may also obtain, at inputs of the corresponding power conversion circuits, the voltage currently provided by the battery pack in the battery cluster B. Because only the first switch is turned on in the battery cluster B, the voltage obtained by the controller in the converter b1 and the controller in the converter b2 remains unchanged, and the change information of the direct current voltage is sent to the controller A0 in the battery cluster A through the communication connection. The controller A0 in the battery cluster A receives the maintaining information of the direct current voltage from the converter b1 and the converter b2, controls the voltage output by the battery pack to the converter a1 and the converter a2 to increase from U1 to U2, and outputs the signal indicating a cable connection error. The controller in the battery cluster B receives the change information of the direct current voltage from the converter a1 and the converter a2, does not control the voltage output by the battery pack to the converter b1 and the converter b2 to change, and also outputs the signal indicating a cable connection error. Before supplying power to the load, the power supply system controls voltages between the energy storage units and the power converter to change by controlling an action of the switch in the soft-start circuit in the energy storage unit, to check cable connections between the energy storage units and the power converters, so as to prevent the power supply system from working when a connection abnormality occurs in cables between the energy storage units and the power converters. This greatly improves efficiency of cable connection checking and working security of the power supply system. In addition, no additional hardware is required, and normal communication between other devices is not affected, so that accuracy of cable connection checking is high.

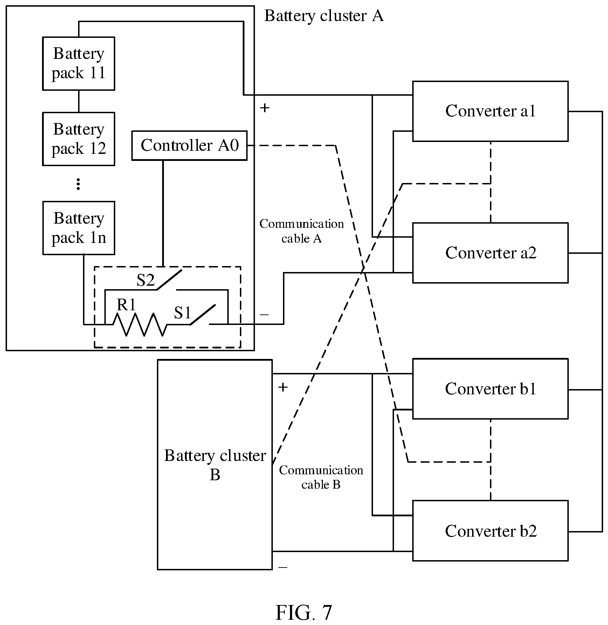

In some feasible implementations, the switch included in the soft-start circuit in each battery cluster may be connected in series between the negative electrode of the direct current power supply and the negative input of the converter. FIG. 7 is a schematic of another structure of a power supply system according to this application. In the power supply system shown in FIG. 7, one end of the battery pack 1n is connected to the negative input of the converter a1 and the negative input of the converter a2 through power cables, and the switch S1 and the resistor R1 connected in series are located on the power cable between the battery pack 11 and the negative input of the converter a1. The controller A0 in the battery cluster A may control actions of the switch S1 and the switch S2, so that the voltage output by the battery pack in the battery cluster A to the converter a1 and the converter a2 changes. In this way, cable connections between the battery cluster and the converter are checked. For a specific process, refer to the descriptions about the power supply system shown in FIG. 6. Details are not described herein again.

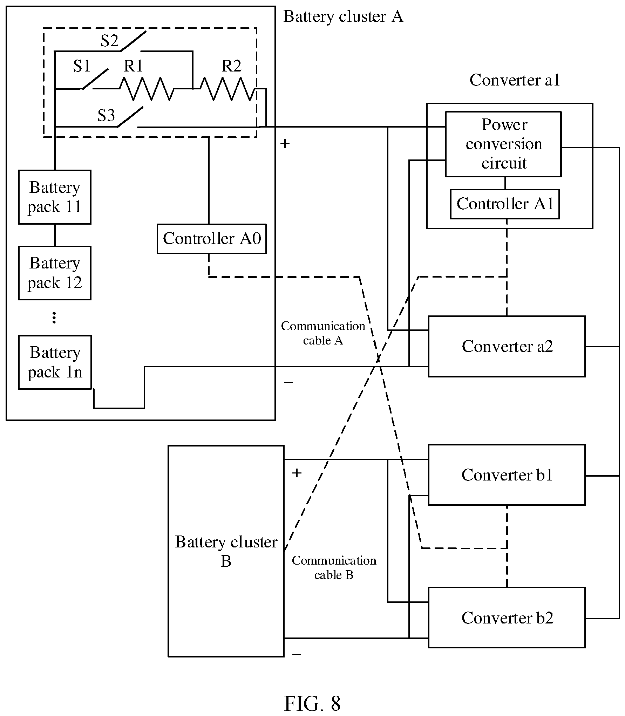

In some feasible implementations, the soft-start circuit in the battery cluster may include a first switch, a second switch, a third switch, a second resistor, and a third resistor, the first resistor is connected in series to the first switch, the second switch is connected in parallel to two ends of the first resistor and the first switch that are connected in series, one end of the second resistor is connected to connection ends of the first resistor and the second switch, and the other end of the second resistor is connected to connection ends of the first switch and the second switch via the third switch. The first controller in the battery cluster is configured to control the first switch to be turned on, so that a voltage output by the battery pack in the battery cluster to the corresponding converter is a third voltage. The first controller in the battery cluster is further configured to: after the second controller in the converter corresponding to the battery cluster obtains the first voltage, control the second switch to be turned on, so that the voltage output by the battery pack in the battery cluster to the corresponding converter is increased to a fourth voltage. An absolute value of a difference between the third voltage and the fourth voltage is greater than the preset threshold. Specifically, in a cable connection checking process, the controllers in the battery clusters may control first switches respectively included in the battery clusters to be turned on, and sequentially control second switches to be turned on, to control voltages output by the battery clusters in which the controllers respectively are located to change, until any controller sends the signal indicating a cable connection error. FIG. 8 is a schematic of another structure of a power supply system according to this application. In the power supply system shown in FIG. 8, the soft-start circuit in the battery cluster A includes a switch S1, a switch S2, a switch S3, a resistor R1, and a resistor R2. One end of the battery pack 11 in the battery cluster A is connected to the positive input of the converter a1 and the positive input of the converter a2 through power cables, and the switch S1 and the resistor R1 that are connected in series and that are included in the battery cluster are located on a power cable between the battery pack 11 and the positive input of the converter a1. The switch S2 in the battery cluster is connected in parallel to two ends of the switch S1 and the resistor R1 that are connected in series. One end of the resistor R2 is connected to connection ends of the resistor R1 and the switch S2, and the other end of the resistor R2 is connected to connection ends of the switch S1 and the switch S2 via the switch S3. Composition and a component connection manner of a soft-start circuit in the battery cluster B in the power supply system are similar to those of the soft-start circuit in the battery cluster A. Details are not described herein again. In a cable connection check process, the controller in each battery cluster may control the first switch respectively included in the battery cluster to be turned on. For example, the controller A0 in the battery cluster A may control the switch S1 to be turned on, so that a voltage output by the battery pack in the battery cluster A to the converter a1 and the converter a2 is U3. Then, the controller A1 in the converter a1 and the controller A2 (not shown in FIG. 8) in the converter a2 may obtain U3 at inputs of the corresponding power conversion circuits. Similarly, the controller in the converter b1 and the controller in the converter b2 may also obtain, at inputs of the corresponding power conversion circuits, the voltage currently provided by the battery pack in the battery cluster B. The controllers in the battery clusters may sequentially control corresponding second switches to be turned on, to control voltages output by the battery clusters in which the controllers are located to change. For example, the controller A0 in the battery cluster A may control the switch S2 to be turned on, so that the resistor R1 is bypassed, and the voltage output by the battery pack in the battery cluster A to the converter a1 and the converter a2 is increased to U4. The controller A1 in the converter a1 and the controller A2 in the converter a2 may obtain U4 at inputs of the corresponding power conversion circuits, and detect that an absolute value of a difference between U3 and U4 is greater than the preset threshold. The controller A1 in the converter a1 and the controller A2 in the converter a2 may send the change information of the direct current voltage to the controller in the battery cluster B through the communication connection. The controller in the converter b1 and the controller in the converter b2 may also obtain, at inputs of the corresponding power conversion circuits, the voltage currently provided by the battery pack in the battery cluster B. Because only the first switch is turned on in the battery cluster B, the voltage obtained by the controller in the converter b1 and the controller in the converter b2 remains unchanged, and the change information of the direct current voltage is sent to the controller A0 in the battery cluster A through the communication connection. The controller A0 in the battery cluster A receives the maintaining information of the direct current voltage from the converter b1 and the converter b2, controls the voltage output by the battery pack to the converter a1 and the converter a2 to increase from U3 to U4, and outputs the signal indicating a cable connection error. The controller in the battery cluster B receives the change information of the direct current voltage from the converter a1 and the converter a2, does not control the voltage output by the battery pack to the converter b1 and the converter b2 to change, and also outputs the signal indicating a cable connection error. Before supplying power to the load, the power supply system controls an action of the switch in the soft-start circuit in the energy storage unit, so that the voltage between the energy storage unit and the power converter changes. The cable connection between the energy storage unit and the power converter is checked, to prevent the power supply system from working when a connection abnormality occurs in the cable between the energy storage unit and the power converter. In addition, when the first switch in the soft-start circuit is turned on, the first resistor and the second resistor are connected in series to the power connection between the energy storage unit and the power converter. When the second switch in the soft-start circuit is turned on, the first resistor is connected in series to the power connection between the energy storage unit and the power converter. This can avoid excessively large change amplitude of the output voltage of the energy storage unit before and after the second switch is turned on, to protect the switch in the soft-start circuit.

In this application, before supplying power to the load, the power supply system checks the cable connection between the energy storage unit and the power converter. In each round of communication connection detection, a first controller in one energy storage unit controls actions of at least two switches included in the energy storage unit, so that a voltage output to a power conversion circuit in a power converter corresponding to the energy storage unit in which the first controller is located changes. Then, the second controller in the plurality of power converters obtains the direct current voltage received by the corresponding power conversion circuit. When detecting that the voltage changes, that is, the change amplitude of the direct current voltage is greater than the preset threshold, the second controller sends, through the communication connection, the change information of the direct current voltage to the first controller that is communicatively connected to the second controller; otherwise, sends the maintaining information of the direct current voltage to the first controller that is communicatively connected to the second controller. When controlling the voltage output by the direct current power supply to change and when receiving the maintaining information of the direct current voltage, or when not controlling the direct current voltage output by the direct current power supply to change and when receiving the change information of the direct current voltage, the first controller in the plurality of energy storage units outputs the signal indicating a cable connection error. In this case, the cable connection error is found in this round of cable connection checking, and cable connection checking ends. Voltages between the energy storage units and the power converter are controlled to change, to check connections of communication cables or power cables between the energy storage units and the power converters, so as to prevent the power supply system from working when a connection abnormality occurs in cables between the energy storage units and the power converters. This greatly improves efficiency of checking a connection of a communication cable or a power cable and working security of the power supply system. In addition, no additional hardware is required, and normal communication between other devices is not affected, so that accuracy of cable connection checking is high.

## Claims

1. A power supply system, wherein the power supply system comprises a plurality of energy storage units and a plurality of power converters, each of the energy storage units is electrically connected to at least one corresponding power converter of the plurality of power converters, each of the energy storage units comprises a direct current power supply, a first controller, and at least two switches, and each of the power converters comprises a power conversion circuit and a second controller;
in each of the energy storage units, the direct current power supply is electrically connected, via the at least two switches, to the power conversion circuit in the power converter corresponding to the energy storage unit, and is configured to output, via the at least two switches, an output direct current voltage to the power conversion circuit in the power converter corresponding to the energy storage unit;
the first controllers in the energy storage unit are sequentially configured to control actions of the at least two corresponding switches, so that direct current voltages output by direct current power supplies in the energy storage units sequentially change;
in each of the power converters, the second controller is configured to: obtain the direct current voltage received by the power conversion circuit in the power converter; and when change amplitude of the direct current voltage is greater than a preset threshold, send, through a communication connection, change information of the direct current voltage to the first controller that is communicatively connected to the second controller; otherwise, send maintaining information of the direct current voltage to the first controller that is communicatively connected to the second controller; and
the first controller in each of the energy storage units is configured to: when controlling the voltage output by the direct current power supply to change and when receiving the maintaining information of the direct current voltage, or when not controlling the direct current voltage output by the direct current power supply to change and when receiving the change information of the direct current voltage, output a signal indicating a cable connection error.

2. The power supply system according to claim 1, wherein the first controller in each of the energy storage units is configured to: receive at least one piece of maintaining information of the direct current voltage or change information of the direct current voltage; and when a quantity of pieces of received maintaining information of the direct current voltage or a quantity of pieces of received change information of the direct current voltage is less than a quantity of power converters corresponding to the energy storage unit, output a signal indicating a communication cable connection error or a power cable connection error.

3. The power supply system according to claim 1, wherein quantities of power converters corresponding to the energy storage units are the same, and the power supply system further comprises an upper-level controller;
the upper-level controller is configured to receive the maintaining information of the direct current voltage or the change information of the direct current voltage that is uploaded by first controllers in the plurality of energy storage units; and
the upper-level controller is configured to: when a quantity of pieces of maintaining information of the direct current voltage or a quantity of pieces of change information of the direct current voltage that is received by a first controller in one of the plurality of energy storage units is less than a quantity of pieces of maintaining information of the direct current voltage or a quantity of pieces of change information of the direct current voltage that is received by a first controller in another energy storage unit, output a signal indicating a communication cable connection error or a power cable connection error.

4. The power supply system according to any one of claims 1 to 3, wherein a positive electrode and a negative electrode of the direct current power supply are respectively connected to a positive input and a negative input of the power conversion circuit, and the at least two switches are connected in series between the positive electrode of the direct current power supply and the positive input of the power conversion circuit.

5. The power supply system according to any one of claims 1 to 3, wherein a positive electrode and a negative electrode of the direct current power supply are respectively connected to a positive input and a negative input of the power conversion circuit, and the at least two switches are connected in series between the negative electrode of the direct current power supply and the negative input of the power conversion circuit.

6. The power supply system according to any one of claims 1 to 5, wherein the energy storage unit comprises a first switch, a second switch, and a first resistor, the first resistor is connected in series to the first switch, and the second switch is connected in parallel to two ends of the first resistor and the first switch that are connected in series;
the first controller in each of the energy storage units is configured to control the first switch to be turned on, so that the direct current voltage output by the direct current power supply in the energy storage unit is a first voltage; and
the first controller in each of the energy storage units is configured to: after the second controller in the power converter corresponding to the first controller obtains the first voltage, control the second switch to be turned on, so that the direct current voltage output by the direct current power supply in the energy storage unit is increased to a second voltage, wherein an absolute value of a difference between the first voltage and the second voltage is greater than the preset threshold.

7. The power supply system according to any one of claims 1 to 5, wherein the energy storage unit comprises a first switch, a second switch, a third switch, a first resistor, a second resistor, and a third resistor, the first resistor is connected in series to the first switch, the second switch is connected in parallel to two ends of the first resistor and the first switch that are connected in series, one end of the second resistor is connected to connection ends of the first resistor and the second switch, and the other end of the second resistor is connected to connection ends of the first switch and the second switch via the third switch;
the first controller in each of the energy storage units is configured to control the first switch to be turned on, so that a direct current voltage output by the direct current power supply in the energy storage unit is a third voltage; and
the first controller in each of the energy storage units is configured to: after the second controller in the power converter corresponding to the first controller obtains the third voltage, control the second switch to be turned on, so that the direct current voltage output by the direct current power supply in the energy storage unit is increased to a fourth voltage, wherein an absolute value of a difference between the third voltage and the fourth voltage is greater than the preset threshold.

8. The power supply system according to any one of claims 1 to 7, wherein the energy storage unit comprises a first communication port, the power converter comprises a second communication port, and first communication ports of the plurality of energy storage units are configured to be connected to second communication ports of the plurality of power converters through communication cables;
the second controller in each of the power converters is configured to transmit, through the communication cable connected to the second communication port, the maintaining information of the direct current voltage or the change information of the direct current voltage to the first controller that is communicatively connected to the second controller; and
the first controller in each of the energy storage units is configured to: when controlling the voltage output by the direct current power supply to change and when receiving the maintaining information of the direct current voltage through the communication cable connected to the first communication port, or when not controlling the direct current voltage output by the direct current power supply to change and when receiving the change information of the direct current voltage through the communication cable connected to the first communication port, output the signal indicating a cable connection error.
